# DEMANDE DE BREVET EUROPEEN

(11) **EP 4 075 504 A1**
(43) Date de publication de la demande: **19.10.2022**
(21) Numéro de dépôt: 22167562.2
(22) Date de dépôt: 11.04.2022
(51) Int. Cl.: H01L 27/11521, H01L 29/423, H01L 21/28, G11C 16/04

(54) **CELLULE MÉMOIRE PROGRAMMABLE ET EFFAÇABLE**

(30) Priorité: 13.04.2021 FR 2103797
(71) Demandeur: STMicroelectronics (Rousset) SAS, 13790 Rousset (FR)
(72) Inventeur: MELUL, Franck, 83110 SANARY SUR MER (FR); MARZAKI, Abderrezak, 13100 AIX EN PROVENCE (FR); AKBAL, Madjid, 13530 TRETS (FR)
(74) Mandataire: Cabinet Beaumont

(57) **Abrégé**

La présente description concerne une cellule mémoire (10) comprenant : un premier caisson (22) dopé d'un premier type de conductivité (N+), en contact avec un deuxième caisson (12) dopé d'un deuxième type de conductivité (P) , le deuxième type de conductivité étant opposé au premier type de conductivité ; un troisième caisson (24) dopé du deuxième type de conductivité (P+), en contact avec un quatrième caisson (14) dopé du premier type de conductivité (N) ; un premier mur (16) en contact avec les deuxième (12) et quatrième (14) caissons, le premier mur comprenant un coeur (16a) conducteur ou semiconducteur et une enveloppe isolante (16b) ; un empilement d'une première couche isolante (27), d'une première couche semiconductrice (26), d'une deuxième couche isolante (29) et d'une deuxième couche semiconductrice (28) recouvrant au moins partiellement les deuxième (12) et quatrième (14) caissons ; et une troisième couche semiconductrice (18) sur laquelle reposent les deuxième (12) et quatrième (14) caissons et le mur (16).

## Description

### Domaine technique

La présente description concerne de façon générale les dispositifs électroniques et plus précisément les dispositifs mémoire, leurs procédés de fabrication et leurs procédés d'utilisation.

### Technique antérieure

Il existe de nombreux types de cellules mémoire. En particulier, il existe des cellules mémoire dites eSTM (embedded Select in Trench Memory - mémoire embarquée à sélection en tranchée). Une cellule mémoire de type eSTM est une cellule mémoire réinscriptible utilisée typiquement dans les circuits mémoires de type flash.

Les cellules mémoire eSTM sont arrangées en matrices, de manière à former des lignes et des colonnes. Les cellules d'une même ligne sont reliées entre elles par un élément de connexion correspondant à une ligne de bit. Les cellules d'une même colonne sont reliées entre elles par un élément de connexion correspondant à une ligne de mot. Les cellules de la matrice peuvent être programmées et lues bit par bit, c'est-à-dire cellule par cellule. Cependant, les cellules eSTM sont effacées ligne par ligne.

### Résumé de l'invention

Il existe un besoin pour une cellule mémoire de type eSTM pouvant être effacée bit par bit.

Il existe un besoin pour une cellule mémoire de type eSTM pouvant être effacée plus rapidement.

Il existe un besoin pour une cellule mémoire de type eSTM plus fiable.

Il existe un besoin pour une cellule mémoire de type eSTM pouvant être commandée par des tensions plus faibles que les cellules mémoire de type eSTM connues.

Un mode de réalisation pallie tout ou partie des inconvénients des cellules mémoire de type eSTM connues.

Un mode de réalisation prévoit une cellule mémoire comprenant :
un premier caisson dopé d'un premier type de conductivité, en contact avec un deuxième caisson dopé d'un deuxième type de conductivité, le deuxième type de conductivité étant opposé au premier type de conductivité ;
un troisième caisson dopé du deuxième type de conductivité, en contact avec un quatrième caisson dopé du premier type de conductivité ;
un premier mur en contact avec les deuxième et quatrième caissons, le premier mur comprenant un coeur conducteur ou semiconducteur et une enveloppe isolante ;
un empilement d'une première couche isolante, d'une première couche semiconductrice, d'une deuxième couche isolante et d'une deuxième couche semiconductrice recouvrant au moins partiellement les deuxième et quatrième caissons ; et
une troisième couche semiconductrice sur laquelle reposent les deuxième et quatrième caissons et le mur.

Selon un mode de réalisation, le premier type de conductivité est le type N, et le deuxième type de conductivité est le type P.

Selon un mode de réalisation, les deuxième et quatrième caissons sont séparés par le premier mur conducteur.

Selon un mode de réalisation, l'empilement de couches recouvre le premier mur.

Selon un mode de réalisation, la troisième couche est séparée du quatrième caisson par un caisson semiconducteur dopé du deuxième type de conductivité.

Selon un mode de réalisation, les deuxième et quatrième caissons sont séparés par un deuxième mur isolant.

Selon un mode de réalisation, l'empilement de couches recouvre le deuxième mur.

Un autre mode de réalisation prévoit une mémoire comprenant une matrice de cellules mémoire telles que décrites précédemment, dans lequel chaque colonne de la matrice comprend une deuxième couche semiconductrice et un premier mur communs aux cellules de la colonne.

Un autre mode de réalisation prévoit un procédé de commande d'une cellule mémoire telle que décrite précédemment, comprenant une étape de programmation durant laquelle :
les deuxième, troisième et quatrième caissons et la troisième couche sont à un premier potentiel de référence ;
le premier caisson est mis à un deuxième potentiel positif, supérieur au premier potentiel de référence ;
la deuxième couche est mise à un troisième potentiel positif, supérieur au deuxième potentiel positif ; et
le premier mur est mis à un quatrième potentiel égal à la tension de seuil d'un transistor équivalent aux premier, deuxième, et troisième caissons et à l'empilement de couches.

Selon un mode de réalisation, le premier potentiel de référence est la masse, le deuxième potentiel positif est sensiblement égal à 5 V, le troisième potentiel est sensiblement égal à 12 V, et le quatrième potentiel est compris entre 0,5 V et 1,5 V.

Un autre mode de réalisation prévoit un procédé de commande d'une cellule mémoire telle que décrite précédemment, comprenant une étape de lecture durant laquelle :
les deuxième, troisième et quatrième caissons et la deuxième couche semiconductrice et la troisième couche sont à un cinquième potentiel de référence ;
le premier caisson est mis à un sixième potentiel positif, supérieur au cinquième potentiel de référence ;
le premier mur est mis à un septième potentiel positif, supérieur au sixième potentiel positif.

Selon un mode de réalisation, le cinquième potentiel de référence est la masse, le sixième potentiel positif est sensiblement égal à 0,7 V, et le septième potentiel positif est sensiblement égal à 3 V.

Un autre mode de réalisation prévoit un procédé de commande d'une cellule mémoire telle que décrite précédemment, comprenant une étape d'effaçage durant laquelle :
les premier, deuxième et troisième caissons et la troisième couche sont à un huitième potentiel de référence ;
le quatrième caisson est mis à un neuvième potentiel, inférieur au huitième potentiel de référence ;
la deuxième couche semiconductrice est mise à un dixième potentiel, inférieur au neuvième potentiel ; et
le premier mur est mis à un onzième potentiel égal à la tension de seuil d'un transistor équivalent aux deuxième, troisième et quatrième caissons et à l'empilement de couches.

Selon un mode de réalisation, le huitième potentiel de référence est la masse, le neuvième potentiel est sensiblement égal à -5 V, le dixième potentiel est sensiblement égal à -10 V et le onzième potentiel est compris entre -1,5 V et -0,5 V.

Selon un mode de réalisation, le huitième potentiel de référence est sensiblement égal à 10 V, le neuvième potentiel est sensiblement égal à 5 V, le dixième potentiel est la masse et le onzième potentiel est compris entre 5 V et 15 V.

Selon un mode de réalisation, le huitième potentiel de référence est sensiblement égal à 5 V, le neuvième potentiel est la masse, le dixième potentiel est sensiblement égal à -5 V et le onzième potentiel est compris entre 0 V et 10 V.

Selon un mode de réalisation, l'étape de programmation et l'étape d'effaçage ont sensiblement la même durée.

Un autre mode de réalisation prévoit un procédé de fabrication d'une cellule mémoire telle que décrite précédemment, comprenant :
a. la formation de la troisième couche semiconductrice par implantation de dopants dans un substrat semiconducteur ;
b. la formation du deuxième caisson par implantation de dopants dans le substrat ;
c. la formation du quatrième caisson par implantation de dopants dans le substrat ;
d. la formation du premier mur entre les deuxième et troisième caissons ;
e. la formation de l'empilement sur une partie des deuxième et quatrième caissons et sur le premier mur ;
f. la formation du premier caisson par implantation de dopants dans le deuxième caisson ; et
g. la formation du troisième caisson par implantation de dopants dans le quatrième caisson.

Un autre mode de réalisation prévoit un procédé de fabrication d'une première cellule mémoire telle que décrite précédemment et d'une deuxième cellule mémoire de type eSTM, dans lequel la première cellule mémoire est formée par les étapes a, b, c, d, e, f, et g du procédé tel que décrit précédemment, la deuxième cellule mémoire étant formée par les étapes a, b, d, e, f.

Un autre mode de réalisation prévoit un procédé de fabrication d'une première cellule mémoire telle que décrite précédemment et d'un transistor, la première cellule étant formée par le procédé décrit précédemment, dans lequel la grille du transistor est formée par l'étape e et les régions de drain et de source sont formées par l'étape f ou g.

Un autre mode de réalisation prévoit un procédé de fabrication d'une première cellule mémoire telle que décrite précédemment, d'un transistor et d'une deuxième cellule mémoire de type eSTM, la première cellule étant formée par le procédé décrit précédemment, la deuxième cellule étant formée par le procédé décrit précédemment et le transistor étant formé par le procédé décrit précédemment.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente des vues A, B, C et D d'un mode de réalisation d'une cellule mémoire ;
la figure 2 illustre une étape de programmation de la cellule de la figure 1 ;
la figure 3 illustre une étape de lecture de la cellule de la figure 1 ;
la figure 4 représente des vues A, B et C illustrant différents exemples d'étapes d'effaçage de la cellule de la figure 1 ;
la figure 5 représente un autre mode de réalisation d'une cellule mémoire ;
la figure 6 représente des vues A, B, C, et D d'un autre mode de réalisation d'une cellule mémoire ;
la figure 7 illustre une étape d'un procédé de fabrication du mode de réalisation de la figure 1 ;
la figure 8 illustre une autre étape d'un procédé de fabrication du mode de réalisation de la figure 1 ;
la figure 9 illustre une autre étape d'un procédé de fabrication du mode de réalisation de la figure 1 ;
la figure 10 illustre une autre étape d'un procédé de fabrication du mode de réalisation de la figure 1 ; et
la figure 11 illustre une autre étape d'un procédé de fabrication du mode de réalisation de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

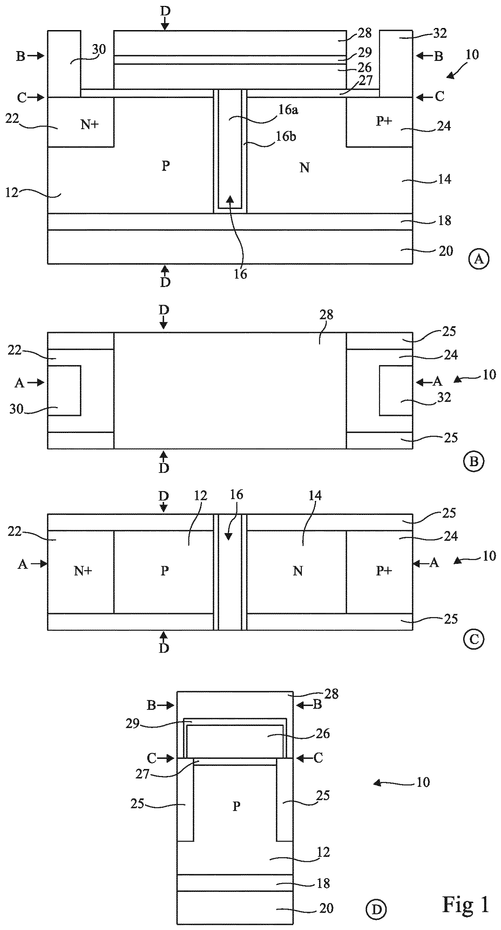

La figure 1 représente des vues A, B, C et D d'un mode de réalisation d'une cellule mémoire 10. Plus précisément, la figure 1 comprend :
une vue en coupe A selon un plan A-A des vues B et C ;
une vue de dessus B selon un plan B-B des vues A et D ;
une vue de dessus C selon un plan C-C des vues A et D ; et
une vue en coupe D selon un plan D-D des vues B et C.

Les plans B-B et C-C sont parallèles entre eux et orthogonaux aux plans A-A et D-D. Le plan A-A est orthogonal aux plans B-B, C-C et D-D. De même, le plan D-D est orthogonal aux plans A-A, B-B et C-C. Le plan A-A correspond à la direction d'une ligne de bit d'une matrice de cellules élémentaires identiques ou similaires. Le plan D-D correspond à la direction d'une ligne de mot de la matrice.

La cellule mémoire 10 comprend un caisson 12. Le caisson 12 est en un matériau semiconducteur, par exemple en silicium. Le caisson 12 est dopé de type P. Le caisson 12 est par exemple dopé avec du bore. La concentration en dopants dans le caisson 12 est par exemple comprise entre 10¹⁴ et 5×10¹⁵ at.cm^ (-3) .

La cellule 10 comprend, de plus, un caisson 14. Le caisson 14 est en un matériau semiconducteur, par exemple en silicium. Le caisson 14 est dopé de type N. Le caisson 14 est par exemple dopé avec du phosphore. La concentration en dopants dans le caisson 14 est par exemple comprise entre 10¹⁴ et 5×10¹⁵ at.cm^ (-3) .

La cellule 10 comprend, de plus, un mur 16 séparant les caissons 12 et 14. Le mur 16 comprend par exemple un coeur 16a, par exemple en un métal ou en un matériau semiconducteur, de préférence en silicium polycristallin, et une enveloppe isolante 16b entourant le coeur 16a, par exemple en oxyde de silicium. En particulier, l'enveloppe isolante 16b sépare le coeur 16a des caissons 12 et 14. Le mur 16 est par exemple en silicium polycristallin. De préférence, les caissons 12 et 14 sont entièrement séparés par le mur 16. Le mur 16 s'étend de préférence au moins sur toute la hauteur des caissons 12 et 14. Ainsi, les caissons 12 et 14 ne sont, de préférence, pas en contact l'un avec l'autre. Les caissons 12 et 14 sont de préférence en contact avec le mur 16.

De préférence, les caissons 12 et 14 et le mur 16 ont des faces inférieures coplanaires entre elles. De préférence, la cellule 10 comprend une couche 18 sur laquelle reposent les faces inférieures des caissons 12 et 14 et du mur 16. Dans cet exemple, les faces inférieures des caissons 12 et 14 et du mur 16 sont en contact avec la face supérieure de la couche 18. La couche 18 est de préférence en un matériau semiconducteur, par exemple du silicium, par exemple du silicium dopé de type N. La couche 18 repose sur un substrat 20 dopé de type P. Le substrat 20 est par exemple en un matériau semiconducteur par exemple dopé avec du bore.

La cellule 10 comprend un caisson 22 situé dans une partie supérieure du caisson 12. Le caisson 22 est en un matériau semiconducteur, par exemple en silicium. Le caisson 22 est dopé de type N (N+). Le caisson 22 est par exemple dopé avec du phosphore. La concentration en dopants dans le caisson 22 est supérieure à la concentration en dopants dans le caisson 14. La concentration en dopants dans le caisson 22 est par exemple comprise entre 10¹⁸ et 10²⁰ at.cm^ (-3) .

Le caisson 22 est séparé du mur 16 par une partie du caisson 12. Autrement dit, une partie du caisson 12 est située entre le caisson 22 et le mur 16. Le mur 16 et le caisson 22 ne sont ainsi pas en contact l'un avec l'autre. Le caisson 22 s'étend à partir de la face supérieure du caisson 12. La face supérieure du caisson 22 est de préférence coplanaire avec la face supérieure du mur 16 et avec la face supérieure de la partie du caisson 12 située entre le caisson 22 et le mur 16.

Similairement, la cellule 10 comprend un caisson 24 situé dans une partie supérieure du caisson 14. Le caisson 24 est en un matériau semiconducteur, par exemple en silicium. Le caisson 24 est dopé de type P (P+). Le caisson 24 est par exemple dopé avec du bore. La concentration en dopants dans le caisson 24 est supérieure à la concentration de dopants dans le caisson 12. La concentration en dopants dans le caisson 24 est par exemple comprise entre 10¹⁸ et 10²⁰ at.cm^(-3) .

Le caisson 24 est séparé du mur 16 par une partie du caisson 14. Autrement dit, une partie du caisson 14 est située entre le caisson 24 et le mur 16. Le mur 16 et le caisson 24 ne sont ainsi pas en contact l'un avec l'autre. Le caisson 24 s'étend à partir de la face supérieure du caisson 14. La face supérieure du caisson 24 est de préférence coplanaire avec la face supérieure du mur 16 et avec la face supérieure de la partie du caisson 14 située entre le caisson 24 et le mur 16.

Le plan C-C de la vue C illustre les faces supérieures des caissons 12, 14, 22, 24 et du mur 16. Dans le plan C-C, la cellule comprend ainsi de gauche à droite le caisson 22, le caisson 12, le mur 16, le caisson 14 et le caisson 24.

Le type de dopage, N ou P, du caisson 12 est le type opposé du type de dopage du caisson 14. Similairement, le type de dopage du caisson 22 est le type opposé du type de dopage du caisson 24. De plus, le type de dopage du caisson 22 est le type opposé du type de dopage du caisson 12. Le type de dopage du caisson 24 est le type opposé du type de dopage du caisson 14. Ainsi, les caissons 22 et 14 ont des types de dopage, N ou P, identiques et les caissons 24 et 12 ont des types de dopage identiques.

De préférence, les dimensions des caissons 12 et 14 sont sensiblement identiques. De même, les dimensions des caissons 22 et 24 sont sensiblement identiques.

La cellule 10 est séparée des cellules voisines appartenant à des lignes différentes par des murs isolants 25. Les murs isolants 25 sont par exemple en oxyde de silicium. Les murs isolants 25 s'étendent de préférence depuis le plan des faces supérieures des caissons 22 et 24, c'est-à-dire le plan C-C. Les murs 25 s'étendent de préférence le long de toute la cellule dans la direction des lignes. Ainsi, les murs 25 s'étendent le long des caissons 22, 24, 12 et 14. Les murs 25 sont de préférence traversés par le mur 16. De préférence, les murs 25 s'étendent sur une hauteur inférieure à la hauteur du mur 16, c'est-à-dire une hauteur inférieure à la distance entre le plan C-C et la couche 18. Ainsi, les murs 25 ne s'étendent de préférence pas sur toute la hauteur des caissons 12 et 14. Cela permet de connecter électriquement les caissons 12 et 14 d'une cellule 10 à des cellules 10 voisines. Les murs 25 sont de préférence séparés de la couche 18 par une partie du caisson 12 ou du caisson 14. De préférence, les murs 25 s'étendent sur une hauteur supérieure à la hauteur des caissons 22 et 24.

La cellule 10 comprend en outre un empilement d'une couche 27 isolante, d'une couche 26 en un métal ou en un matériau semiconducteur, par exemple en silicium polycristallin, d'une couche isolante 29 et d'une couche 28 en un métal ou en un matériau semiconducteur, par exemple en silicium polycristallin. De préférence, les couches 27 et 29 sont en des matériaux différents. Par exemple, la couche 27 est en oxyde de silicium et la couche 29 est un empilement d'une couche d'oxyde de silicium, d'une couche de nitrure de silicium et d'une couche d'oxyde de silicium. De préférence, les couches 26 et 28 sont en le même matériau, par exemple en silicium polycristallin.

La couche 27 repose sur la face supérieure des caissons 12, 14, 22 et 24. La couche 26 repose sur la couche 27. De préférence, la couche 26 a des dimensions horizontales inférieures aux dimensions horizontales de la couche 27, c'est-à-dire des dimensions inférieures dans les directions des lignes de bit et de mot. De préférence, la couche 27 s'étend de manière continue sur toute la face supérieure des caissons 12 et 14 et au moins partiellement sur la face supérieure des caissons 22 et 24. La couche 27 s'étend, dans la direction des colonnes, sur toute la largeur des caissons 22 et 24. De préférence, la couche 27 s'étend depuis un des murs 25, de préférence depuis une face latérale d'un des murs 25, jusqu'à l'autre mur 25 de la cellule, de préférence jusqu'à une face latérale de l'autre mur 25. La couche 27 s'étend, de préférence, dans la direction de la ligne de la matrice, à partir du mur 16. La couche 27 sépare la couche 26 des caissons 12 et 14. De préférence, la couche 26 s'étend de manière continue en regard de toute la face supérieure des caissons 12 et 14. La couche 26 s'étend, dans la direction des colonnes, sur toute la largeur des caissons 22 et 24. De préférence, la couche 26 s'étend depuis un des murs 25 jusqu'à un autre mur 25 de la cellule. La couche 26 s'étend, de préférence, dans la direction de la ligne de la matrice, du caisson 22 au caisson 24. De préférence, la couche 26 s'étend du niveau de la zone de contact entre les caissons 12 et 22 au niveau de la zone de contact entre les caissons 14 et 24. De préférence, la couche 26 ne s'étend pas en regard des caissons 22 et 24.

La couche 29 recouvre de préférence entièrement la couche 26. De préférence, la couche 29 recouvre la face supérieure de la couche 26 et des faces latérales de la couche 26, par exemple les faces latérales de la couche 26 dans la direction des colonnes de la matrice. De préférence, la couche 29 a une dimension, dans la direction des lignes de la matrice, sensiblement égale à la dimension de la couche 26 dans la direction des lignes.

La couche 28 recouvre de préférence entièrement la couche 29. La couche 28 est séparée de la couche 26 par la couche 29. De préférence, la couche 28 a une dimension, dans la direction des lignes, sensiblement égale à la dimension de la couche 26 dans la direction des lignes.

De préférence, la dimension de la couche 28 dans la direction des colonnes est supérieure à la dimension de la couche 26 dans la direction des colonnes. De préférence, la couche 28 est commune à plusieurs cellules d'une même colonne, de préférence à toutes les cellules d'une colonne. Ainsi, la couche 28 recouvre, de préférence, les couches 26 de plusieurs cellules d'une même colonne, et recouvre les murs 25 séparant lesdites cellules.

La cellule comprend, de plus, des éléments de contact 30 et 32, par exemple des vias conducteurs. Les éléments 30 et 32 sont par exemple en un métal. L'élément 30 est en contact avec le caisson 22 et l'élément 32 est en contact avec le caisson 24. Les éléments 30 et 32 ne sont pas en contact avec les couches 26 et 28. L'élément 30 n'est de préférence pas en contact avec le caisson 12. L'élément 32 n'est de préférence pas en contact avec le caisson 14. Les éléments 30 et 32 sont chacun relié à un élément de connexion formant une ligne de bit.

La cellule 10 est constituée de deux ensembles de deux transistors MOSFET (Metal Oxide Semiconductor Field Effect Transistor - transistor à effet de champ à structure métal-oxyde-semiconducteur) en série. Un ensemble comprend des transistors à canal N constitués par la couche 18, le caisson 12 et le caisson 22, les couches 26, 27, 28 et 29 constituant la grille. L'autre ensemble comprend des transistors à canal P constitués par le caisson 12, le caisson 14 et le caisson 24, les couches 26, 27, 28 et 29 constituant la grille.

La couche 18 est de préférence commune à toutes les cellules mémoire du type de la cellule 10 dans une même matrice de cellules.

Le mur 16 est de préférence commun à toutes les cellules de la colonne de la matrice. Le mur 16 s'étend d'une cellule à une cellule voisine en traversant les murs isolants 25.

La ligne de la matrice de cellule comprend, par exemple, des cellules voisines symétriques entre elles selon un plan de symétrie parallèle au plan D-D et situé par exemple à gauche de la vue A. Les caissons 12 et 22 s'étendent alors vers la gauche dans la vue A de manière à former des formes similaires aux formes représentées en figure 1. Similairement, le caisson 24 et le caisson 14 sont, par exemple, communs avec une cellule voisine de la même ligne de la matrice située vers la droite de la vue A.

De préférence, les caissons 22 d'une même ligne de la matrice sont reliés entre eux par l'intermédiaire des éléments 30 et éventuellement d'autres éléments de connexion non représentés. Similairement, les caissons 24 d'une même ligne de la matrice sont reliés entre eux par l'intermédiaire des éléments 32 et éventuellement d'autres éléments de connexion non représentés.

De plus, le caisson 12 et le caisson 14 sont, de préférence, communs à toutes les cellules de la colonne de la matrice. Les caissons 12 et 14 s'étendent sous les murs 25. Par exemple, les caissons 12 et 14 sont chacun reliés par un contact en bout de ligne à un nœud d'application d'une tension.

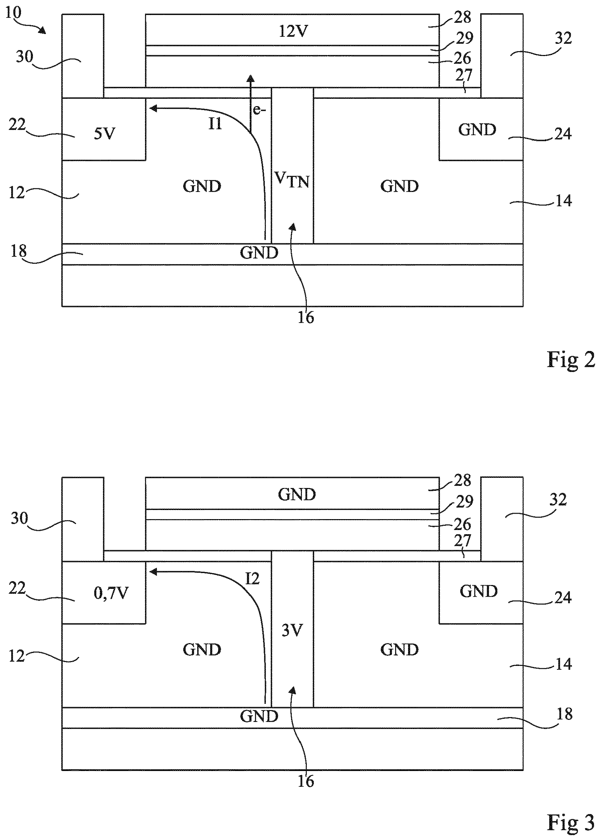

La figure 2 illustre une étape de programmation de la cellule de la figure 1. Il s'agit donc d'une étape au cours de laquelle la cellule mémoire passera d'une première valeur binaire, par exemple la valeur 0, à une deuxième valeur binaire, par exemple la valeur 1.

Lors de la programmation de la cellule 10, les caissons 12, 14, et 24 sont mis à un même potentiel de référence GND, par exemple la masse, c'est-à-dire un potentiel de 0 V. La couche 18 est de même mise au potentiel de référence GND. Le caisson 22 est mis à un potentiel supérieur au potentiel auquel est mise la couche 18. Le caisson 22 est de préférence mis à un potentiel positif, par exemple un potentiel compris entre 3 V et 10 V, par exemple sensiblement égal à 5 V. De plus, la couche 28 est mise à un potentiel supérieur au potentiel auquel est mis le caisson 22. La couche 28 est par exemple mise à un potentiel compris entre 10 V et 15 V, par exemple sensiblement égal à 12 V.

Le mur 16 est mis à un potentiel sensiblement égal à une tension de seuil V_{TN} du transistor constitué par les caissons 12 et 22 et les couches 18, 26 et 28, c'est-à-dire le transistor à canal P. Le mur 16 est mis à un potentiel permettant d'ouvrir le canal du transistor à canal P de la cellule. Le mur 16 est ainsi mis à un potentiel de préférence compris entre 0,5 V et 1,5 V, de préférence sensiblement égal à 1 V.

Plus généralement, les différentes parties de la cellule sont mises à des potentiels permettant, durant la programmation de la cellule 10, de former un courant I1, représenté par une flèche en figure 2, entre la couche 18 et le caisson 22, le long du mur 16 et de la couche 26. Les potentiels du caissons 22, des couches 28 et 18 et du mur 16 sont tels qu'un phénomène d'injection de porteurs chauds apparait. Ainsi, des porteurs, ici des électrons e-, entrent donc dans la couche 26 à travers la couche 27 et y restent piégés. Cela est représenté par une flèche en figure 2.

La figure 3 illustre une étape de lecture de la cellule de la figure 1.

Au cours de cette étape de lecture, les caissons 12, 14, et 24 sont mis à un même potentiel de référence GND, par exemple la masse. La couche 18 est de même mise au potentiel de référence GND. Le caisson 22 est mis à un potentiel supérieur au potentiel auquel est mise la couche 18. Le caisson 22 est de préférence mis à un potentiel positif, par exemple un potentiel compris entre 0 V et 1 V, par exemple sensiblement égal à 0,7 V. De plus, la couche 28 est mise à un potentiel inférieur au potentiel auquel est mis le caisson 22, de préférence au potentiel de référence GND. Le mur 16 est mis à un potentiel supérieur au potentiel auquel est mis le caisson 22. Par exemple, le mur 16 est mis à un potentiel compris entre 1 V et 5 V.

Plus généralement, les différentes parties de la cellule sont mises à des potentiels permettant, lors de l'étape de lecture :
- de former un courant I2, représenté par une flèche en figure 3, entre la couche 18 et le caisson 22 si une étape de programmation piégeant des porteurs, ici des électrons, dans la couche 26 n'a pas été effectuée et qu'il n'y a donc pas de porteurs, ici des électrons, dans la couche 26 ; et
- de ne pas former de courant entre la couche 18 et le caisson 22 si des porteurs, ici des électrons, sont piégés dans la couche 26.

Une donnée binaire peut ainsi être lue. Si, durant l'étape de lecture décrite, un courant est généré entre la couche 18 et le caisson 22, la cellule mémoire contient une première valeur binaire, par exemple la valeur 0 et si le courant n'est pas généré entre la couche 18 et le caisson 22, la cellule mémoire contient une deuxième valeur binaire, par exemple la valeur 1.

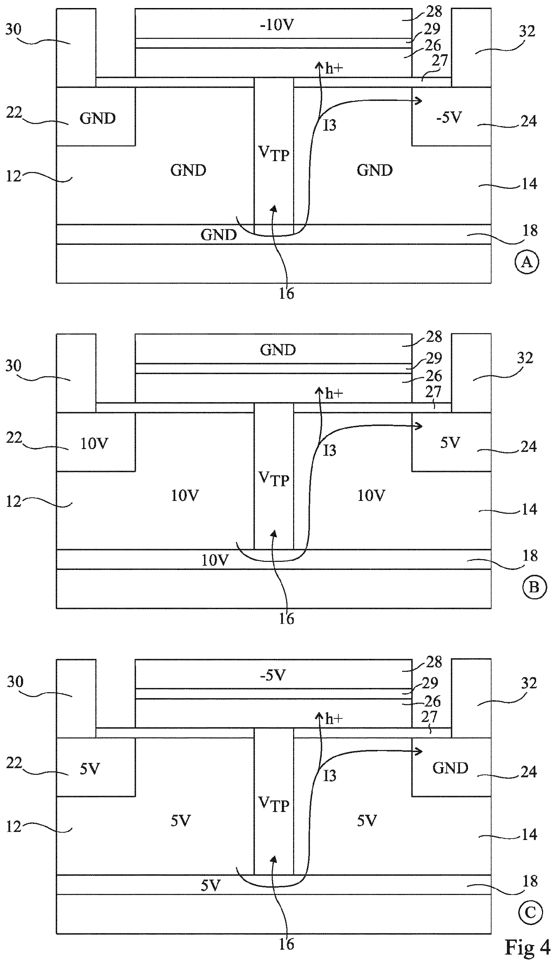

La figure 4 représente des vues A, B et C illustrant différents exemples d'étapes d'effaçage de la cellule de la figure 1.

La vue A représente un premier exemple d'étape d'effaçage de la cellule 10. Durant cette étape, les caissons 12, 14 et 22 et la couche 18 sont mis au potentiel de référence GND. De plus, la couche 28 est mise à un potentiel négatif, sensiblement égal à -10 V. Le caisson 24 est mis à un potentiel négatif, sensiblement égal à -5 V. Le mur 16 est mis à un potentiel de préférence compris entre -0,5 V et -1,5V, de préférence sensiblement égal à -1 V.

La vue B représente un deuxième exemple d'étape d'effaçage de la cellule 10. Durant cette étape, les caissons 12, 14 et 22 et la couche 18 sont mis à un potentiel positif, sensiblement égal à 10 V. De plus, la couche 28 est mise au potentiel de référence GND. Le caisson 24 est mis à un potentiel positif, sensiblement égal à 5 V. Le mur 16 est mis à un potentiel de préférence compris entre 5 V et 15 V, de préférence sensiblement égal à 9 V.

La vue C représente un troisième exemple d'étape d'effaçage de la cellule 10. Durant cette étape, les caissons 12, 14 et 22 et la couche 18 sont mis à un potentiel positif, sensiblement égal à 5 V. De plus, la couche 28 est mise à un potentiel négatif, sensiblement égal à -5 V. Le caisson 24 est mis au potentiel de référence GND. Le mur 16 est mis à un potentiel de préférence compris entre 0 V et 10 V, de préférence sensiblement égal à 4 V.

De manière plus générale, durant une étape d'effaçage de la cellule 10, les potentiels auxquels sont mis les caissons 12, 14 et 22 et la couche 18 sont sensiblement égaux entre eux. Les caissons 12, 14 et 22 et la couche 18 sont mis à un premier potentiel. De plus, le mur 16 est mis à un potentiel sensiblement égal à une tension de seuil V_{TP} du transistor constitué par les caissons 12, 14 et 24 et les couches 18, 26 et 28, c'est-à-dire le transistor à canal P.

En outre, le caisson 24 est mis à un deuxième potentiel, inférieur au premier potentiel. La couche 28 est mis à un troisième potentiel, inférieur au deuxième potentiel. De préférence, la différence entre le premier potentiel et le deuxième potentiel est comprise entre 2 V et 7 V, de préférence sensiblement égale à 5 V. De même, la différence entre le deuxième potentiel et le troisième potentiel est de préférence comprise entre 2 V et 7 V, de préférence sensiblement égale à 5 V. La différence entre le premier potentiel et le deuxième potentiel est de préférence sensiblement égale à la différence entre le deuxième potentiel et le troisième potentiel.

Plus généralement, les différentes parties de la cellule sont mises à des potentiels permettant, lors de l'étape d'effaçage, de former un courant I3, représenté par une flèche dans les vues de la figure 4, entre le caisson 12 et le caisson 24 à travers la couche 18, le long du mur 16 et de la couche 26. Les potentiels du caisson 24, du caisson 12, des couches 28 et 18 et du mur 16 sont tels qu'un phénomène d'injection de porteurs chauds apparait. Ainsi, des porteurs, ici des trous h+, entrent donc dans la couche 26 à travers la couche 27, par effet tunnel, et y restent piégés. Cela est représenté par une flèche dans les vues A, B et C de la figure 4.

Les trous piégés dans la couche 26 compensent les électrons piégés dans la couche 26 lors d'une étape de programmation. Ainsi, lors d'une étape de lecture postérieure à l'étape d'effaçage et en l'absence de nouvelle étape de programmation, l'absence d'électrons assure que le courant I2 sera formé.

De préférence, le nombre de trous générés et piégés dans la couche 26 lors de l'étape d'effaçage est sensiblement égal au nombre d'électrons piégés dans la couche 26 lors de l'étape de programmation précédente, de manière que les trous compensent les électrons. Pour ce faire, la durée de l'étape d'effaçage est de préférence sensiblement la même que la durée de l'étape de programmation.

Dans une matrice mémoire de cellules telles que la cellule 10, il est possible d'effacer des cellules bit par bit. En effet, de manière à effacer la cellule 10, la couche 28 et le mur 16, communs à la colonne de la cellule 10, sont respectivement mis au troisième potentiel et au potentiel V_{TP}. De plus, le caisson 24, relié aux caissons 24 de la ligne de matrice de la cellule 10 par un élément de connexion non représenté formant la ligne de bit, est mis au deuxième potentiel. Les autres couches 28, les autres murs 16 et les autres caissons 24 sont par exemple tous mis au premier potentiel ou sont chacun mis à un potentiel différent du potentiel correspondant à l'effaçage. Ainsi, l'effaçage est effectué uniquement dans une cellule.

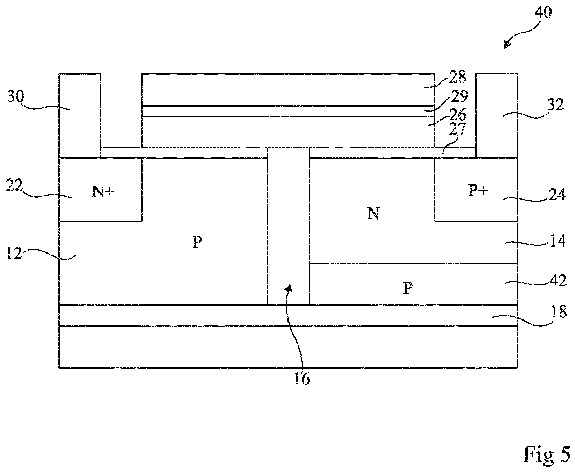

La figure 5 représente un autre mode de réalisation d'une cellule mémoire 40.

La cellule mémoire 40 diffère de la cellule 10 de la figure 1 en ce que le caisson 14 est séparé de la couche 18 par un caisson 42. Le caisson 42 est en un matériau semiconducteur dopé de type P (c'est-à-dire un dopage opposé à celui du caisson 14), par exemple dopé en atomes de bore. La concentration de dopage est par exemple comprise entre 10¹⁴ et 5×10¹⁵ at.cm^ (-3) .

De préférence, le caisson 14 est entièrement séparé de la couche 18 par le caisson 42. Ainsi, le caisson 14 n'est pas en contact avec la couche 18.

Le caisson 42 s'étend à partir de la couche 18. Le caisson 42 s'étend de préférence sur une hauteur inférieure à la distance entre la couche 18 et le caisson 24. Ainsi, le caisson 42 est de préférence séparé du caisson 24 par une partie du caisson 14. De plus, le caisson 42 s'étend de préférence sur une hauteur inférieure à la distance entre la couche 18 et les murs 25 isolants non représentés en figure 5. Ainsi, le caisson 14 s'étend de préférence sur une hauteur supérieure à la hauteur des murs 25. Cela permet d'interconnecter le caisson 14 avec le caisson 14 d'une cellule voisine. Le caisson 14 comprend donc des parties situées sous les murs 25, de telle manière que le caisson 14 puisse être commun à plusieurs cellules, de préférence à toutes les cellules, de la colonne.

De préférence, le caisson 42 est commun entre les cellules d'une même colonne. Le caisson 42 est par exemple commun entre deux cellules voisines d'une même ligne de la matrice.

Selon le mode de réalisation de la figure 5, la cellule 40 comprend un transistor MOSFET à canal N constitué par la couche 18, le caisson 12 et le caisson 22, les couches 26, 27, 28 et 29 constituant la grille. La cellule 40 comprend un transistor MOSFET à canal P constitué par le caisson 42, le caisson 14 et le caisson 24, les couches 26, 27, 28 et 29 constituant la grille.

Le fonctionnement de la cellule 40 est identique au fonctionnement de la cellule 10, le caisson 42 étant mis au même potentiel que le caisson 12 à l'exception du fait que lors de l'étape d'effaçage, le courant I3 est situé entre le caisson 42 et le caisson 24 et non entre le caisson 12 et le caisson 24.

Un avantage du mode de réalisation de la figure 5 est qu'il est possible de choisir la longueur effective du transistor à canal P en choisissant la hauteur du caisson 42.

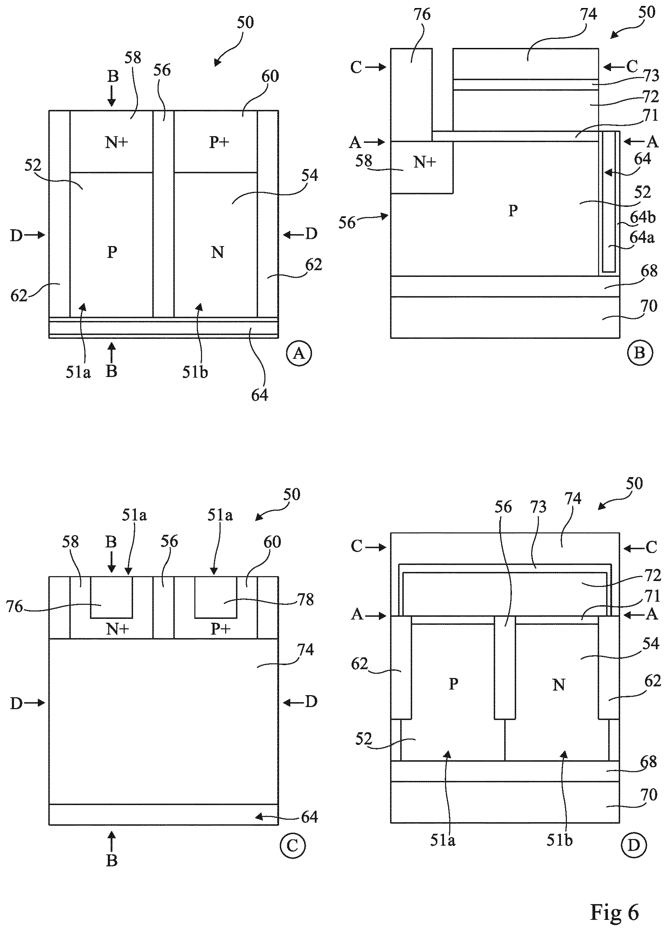

La figure 6 représente des vues A, B, C, et D d'un autre mode de réalisation d'une cellule mémoire 50.

Plus précisément, la figure 6 comprend :
une vue de dessus A selon un plan A-A des vues B et D ;
une vue en coupe B selon un plan B-B des vues A et C ;
une vue de dessus C selon un plan C-C des vues B et D ; et
une vue en coupe D selon un plan D-D des vues A et C.

Les plans A-A et C-C sont parallèles entre eux et orthogonaux aux plans B-B et D-D. Le plan B-B est orthogonal aux plans A-A, C-C et D-D. De même, le plan D-D est orthogonal aux plans A-A, B-B et C-C. Le plan B-B correspond à la direction d'une ligne de la matrice de cellules mémoire. Le plan D-D correspond à la direction d'une colonne de la matrice de cellules mémoire.

La cellule mémoire 50 comprend deux blocs semiconducteurs 51a et 51b. Les blocs 51a et 51b sont de préférence voisins l'un de l'autre. Les blocs 51a et 51b sont de préférence identiques l'un à l'autre au type de conductivité près.

Le bloc semiconducteur 51a comprend un caisson 52. Le caisson 52 est similaire au caisson 12 de la figure 1. Ainsi, le caisson 52 est en un matériau semiconducteur, par exemple en silicium. Le caisson 52 est dopé de type P. Le caisson 52 est par exemple dopé avec du bore. La concentration en dopants dans le caisson 52 est par exemple comprise entre 10¹⁴ et 5×10¹⁵ at.cm^ (-3) .

Le bloc semiconducteur 51a comprend un caisson 58 situé dans le caisson 52. Le caisson 58 est similaire au caisson 22 de la figure 1. Ainsi, le caisson 58 est en un matériau semiconducteur, par exemple en silicium. Le caisson 58 est dopé de type N (N+). Le caisson 58 est par exemple dopé avec du phosphore. La concentration en dopants dans le caisson 58 est supérieure à la concentration de dopants dans le caisson 54. La concentration en dopants dans le caisson 58 est par exemple comprise entre 10¹⁸ et 10²⁰ at.cm^ (-3) .

De préférence, le caisson 58 s'étend depuis le niveau de la face supérieure du caisson 52. Le caisson 58 s'étend de préférence sur une hauteur inférieure à la hauteur de caisson 52. Le caisson 58 s'étend de préférence sur une hauteur inférieure à la hauteur des murs 62. Le caisson 58 s'étend de préférence sur une hauteur inférieure à la hauteur des murs 56.

Le bloc semiconducteur 51b comprend un caisson 54. Le caisson 54 est similaire au caisson 14 de la figure 1. Ainsi, le caisson 54 est en un matériau semiconducteur, par exemple en silicium. Le caisson 54 est dopé de type N. Le caisson 54 est par exemple dopé avec du phosphore. La concentration en dopants dans le caisson 54 est par exemple comprise entre 10¹⁴ et 5×10¹⁵ at.cm^ (-3) .

Similairement, le bloc semiconducteur 51b comprend un caisson 60 situé dans le caisson 54. Le caisson 60 est similaire au caisson 24 de la figure 1. Ainsi, le caisson 60 est en un matériau semiconducteur, par exemple en silicium. Le caisson 60 est dopé de type P (P+). Le caisson 60 est par exemple dopé avec du bore. La concentration en dopants dans le caisson 60 est supérieure à la concentration de dopants dans le caisson 52. La concentration en dopants dans le caisson 60 est par exemple comprise entre 10¹⁸ et 10²⁰ at.cm^ (-3) .

Les blocs 51a et 51b sont situés l'un à côté de l'autre dans la direction d'une colonne. La cellule 50 comprend un mur 56 isolant, par exemple en oxyde de silicium. Le mur 56 s'étend dans la direction d'une ligne de bit. Le mur 56 sépare au moins partiellement les blocs 51a et 51b. De préférence, le mur 56 s'étend sur toute la longueur de la cellule 50, c'est-à-dire le long de toute la cellule 50 dans la direction de la ligne de bit. De préférence, le mur 56 s'étend à partir de la face supérieure des caissons 52 et 54, 58 et 60 et le long des caissons 52 et 54, 58 et 60. De préférence, le mur 56 s'étend le long des caissons 52 et 54, 58 et 60 sur une hauteur inférieure à la hauteur des caissons 52 et 54. Les caissons 52 et 54 sont par exemple en contact l'un avec l'autre sous le mur 64. De préférence, le mur 56 s'étend le long des caissons 52 et 54, 58 et 60 sur une hauteur supérieure à la hauteur des caissons 58 et 60. Ainsi, les caissons 58 et 60 sont entièrement séparés du bloc 51a ou 51b voisins par le mur 56.

De plus, les blocs 51a et 51b sont séparés de cellules voisines dans la direction de la ligne de mot, c'est-à-dire la direction des colonnes par des murs 62 isolants. De préférence, les murs 62 sont identiques au mur 56. Ainsi, la cellule 50 comprend, dans la direction de la ligne de mot, un mur 62, le bloc 51a, le mur 56, le bloc 51b et un autre mur 62.

La colonne de la mémoire comprend une pluralité de cellules 50. La colonne comprend ainsi une alternance de blocs semiconducteurs 51a, 51b et de murs isolants 56, 62 séparant les blocs semiconducteurs. Chaque bloc 51a est voisin d'un bloc 51b avec lequel il forme une cellule 50 et dont il est séparé par un mur 56. Chaque mur 62 sépare donc un bloc 51a ou 51b d'un bloc 51a ou 51b d'une autre cellule.

La cellule 50 comprend de plus un mur 64. Le mur 64 comprend de préférence un coeur 64a conducteur ou semiconducteur, par exemple en un métal ou en un matériau semiconducteur, de préférence en silicium polycristallin, et une enveloppe isolante 64b, de préférence en oxyde de silicium. Le mur 64 s'étend par exemple dans une direction orthogonale des murs 56 et 62. Le mur 64 s'étend de préférence dans la direction de la ligne de mot. Le mur 64 s'étend le long des caissons 52 et 54. Le mur 64 est en contact avec les caissons 52 et 54. De préférence, le mur 64 s'étend sur toute la hauteur des caissons 52 et 54. Les murs 56 et 62 s'étendent de préférence à partir du mur 64.

Le mur 64 sépare par exemple les blocs 51a et 51b d'une cellule 50 des blocs 51a et 51b d'une cellule 50 située dans une autre colonne. Le mur 64 est de préférence commun à toutes les cellules de la colonne.

De préférence, les caissons 52 et 54 et le mur 64 ont des faces inférieures coplanaires entre elles. De préférence, la cellule 50 comprend une couche 66 sur laquelle reposent les faces inférieures des caissons 52 et 54 et du mur 64. La couche 66 est de préférence en un matériau semiconducteur, par exemple du silicium, par exemple du silicium dopé de type N. La couche 66 repose sur un substrat 70, par exemple en un matériau semiconducteur.

La couche 66 est de préférence commune à toutes les cellules mémoire du type de la cellule 50 dans une même matrice mémoire.

Le caisson 58 est séparé du mur 64 par une partie du caisson 52. Autrement dit, une partie du caisson 52 est située entre le caisson 58 et le mur 64. Le mur 64 et le caisson 58 ne sont ainsi pas en contact. Le caisson 58 s'étend à partir de la face supérieure du caisson 52. Le caisson 58 s'étend sur une hauteur inférieure à la hauteur du caisson 52. La face supérieure du caisson 58 est de préférence coplanaire avec la face supérieure du mur 64 et de la partie du caisson 52 située entre le caisson 58 et le mur 64.

Le caisson 60 est séparé du mur 64 par une partie du caisson 54. Autrement dit, une partie du caisson 54 est située entre le caisson 60 et le mur 64. Le mur 64 et le caisson 60 ne sont ainsi pas en contact. Le caisson 60 s'étend à partir de la face supérieure du caisson 54. Le caisson 60 s'étend sur une hauteur inférieure à la hauteur du caisson 54. La face supérieure du caisson 60 est de préférence coplanaire avec la face supérieure du mur 64 et de la partie du caisson 54 située entre le caisson 60 et le mur 64.

Le type de dopage du caisson 52 est le type opposé du type de dopage du caisson 54. Similairement, le type de dopage du caisson 58 est le type opposé du type de dopage du caisson 60. De plus, le type de dopage du caisson 58 est le type opposé du type de dopage du caisson 52. Le type de dopage du caisson 60 est le type opposé du type de dopage du caisson 54. Ainsi, les caissons 58 et 54 ont des types de dopage identiques et les caissons 60 et 52 ont des types de dopage identiques.

De préférence, les dimensions des caissons 52 et 54 sont sensiblement identiques. De même, les dimensions des caissons 58 et 60 sont identiques.

La cellule 50 comprend en outre un empilement d'une couche 71 isolante, d'une couche 72 semiconductrice, d'une couche 73 isolante et d'une couche 74 conductrice ou semiconductrice.

La couche 71 repose sur la face supérieure des caissons 52 et 54. La couche 72 repose sur la couche 71. De préférence, les couches 71 et 72 ont des formes et des dimensions horizontales sensiblement identiques, c'est-à-dire les dimensions dans un plan parallèle au plan A-A. De préférence la couche 72 recouvre entièrement la couche 71. De préférence, la couche 71 s'étend de manière continue sur toute la face supérieure des caissons 52 et 54 et sur la face supérieure du mur 56. La couche 71 s'étend, dans la direction de la ligne de mot, sur toute la largeur des caissons 58 et 60. De préférence, la couche 71 s'étend depuis un des murs 62 à l'autre mur 62. La couche 71 couvre par exemple au moins partiellement chaque mur 62 adjacent à la cellule 50. La couche 71 s'étend de préférence, dans la direction de la ligne de bit, du caisson 58 au mur 64. De préférence, la couche 71 s'étend du niveau de la zone de contact entre les caissons 52 et 58 au niveau de la zone de contact entre le caisson 52 et le mur 64. De préférence, la couche 71 ne repose pas sur les caissons 58 et 60. La couche 71 sépare la couche 72 des caissons 52 et 54.

La couche 73 recouvre les couches 71 et 72. De préférence, la couche 73 recouvre la face supérieure de la couche 72 et des faces latérales des couches 71 et 72, par exemple les faces latérales situées dans la direction des colonnes de la matrice.

La couche 74 est par exemple en silicium polycristallin. La couche 74 recouvre de préférence entièrement la couche 72. De préférence, la couche 74 a une dimension, dans la direction de la ligne de bit, sensiblement égale à la dimension de la couche 72 dans la direction de la ligne de bit.

De préférence, la dimension de la couche 74 dans la direction de la ligne de mot est supérieure à la dimension de la couche 72 dans la direction de la ligne de mot. De préférence, la couche 74 est commune à plusieurs cellules d'une même colonne, de préférence à toutes les cellules d'une colonne. Ainsi, la couche 74 recouvre, de préférence les couches 72 de plusieurs cellules d'une même colonne, et recouvre les murs 62 séparant lesdites cellules et les murs 56 séparant les blocs des différentes cellules.

La cellule comprend de plus des éléments de contact 76 et 78, par exemple des vias conducteurs. Les éléments 76 et 78 sont par exemple en un métal. L'élément 76 est en contact avec le caisson 58 et l'élément 78 est en contact avec le caisson 60. Les éléments 76 et 78 ne sont de préférence pas en contact avec les couches 72 et 74. L'élément 76 n'est pas de préférence en contact avec le caisson 52. L'élément 78 n'est pas de préférence en contact avec le caisson 54.

Le fonctionnement de la cellule 50 est identique au fonctionnement de la cellule 10 de la figure 1. A chaque étape de fonctionnement décrite précédemment en figures 2, 3 et 4 :
- le potentiel du caisson 52 correspond au potentiel du caisson 12,
- le potentiel du caisson 54 correspond au potentiel du caisson 14,
- le potentiel du caisson 58 correspond au potentiel du caisson 22,
- le potentiel du caisson 60 correspond au potentiel du caisson 24,
- le potentiel de la couche 74 correspond au potentiel de la couche 28,
- le potentiel de la couche 66 correspond au potentiel de la couche 18, et
- le potentiel du mur 64 correspond au potentiel du mur 16.

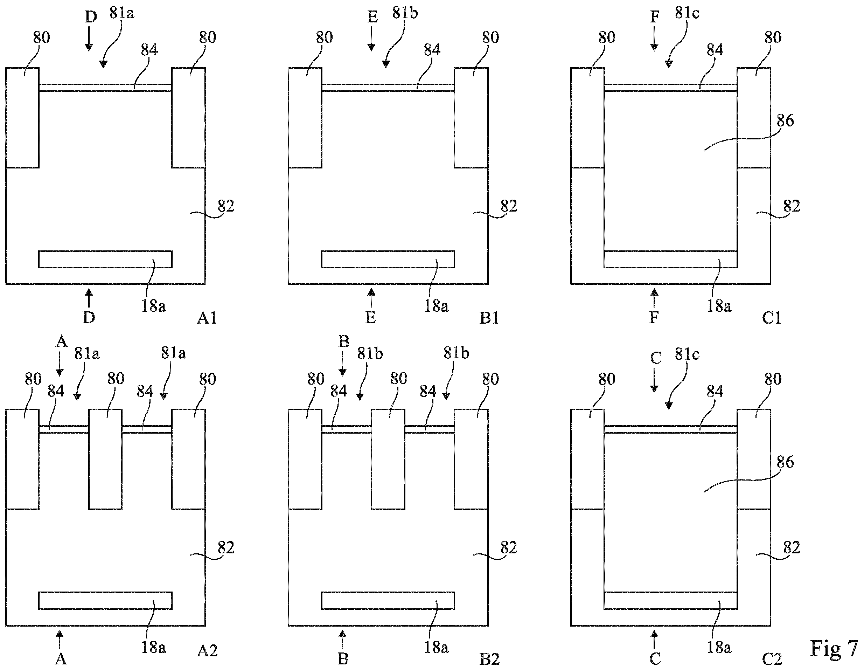

Les figures 7 à 11 illustrent des étapes, de préférence successives, d'un procédé de fabrication d'une cellule mémoire 10 selon le mode de réalisation de la figure 1. Les figures 7 à 11 illustrent en outre un procédé de fabrication d'une cellule mémoire eSTM classique et d'un transistor MOSFET, à canal N dans cet exemple. Les figures 7 à 11 illustrent ainsi la cointégration d'une cellule 10 selon le mode de réalisation de la figure 1 avec une cellule eSTM et un transistor MOSFET. Le procédé de fabrication de la cellule 10 peut être effectué sans la fabrication de la cellule eSTM et du transistor.

Chacune des figures 7 à 11 comprend des vues A1, B1, C1, A2, B2 et C2. Les vues A1, B1 et C1 sont des vues en coupe dans la direction des lignes de bit. Les vues A2, B2 et C2 sont des vues en coupe dans la direction des lignes de mot. Plus précisément, les vues A1 sont des vues en coupe dans la direction des lignes de bit, selon un plan AA de la vue A2, illustrant la fabrication d'une cellule eSTM. Les vues A2 sont des vues en coupe dans la direction des lignes de mot, selon un plan DD de la vue A1, de la structure de la vue A1 de la même figure. Les vues B1 sont des vues en coupe dans la direction des lignes de bit, selon un plan BB de la vue B2, illustrant la fabrication d'une cellule selon le mode de réalisation de la figure 1. Les vues B2 sont des vues en coupe dans la direction des lignes de mot, selon un plan EE de la vue B1, de la structure de la vue B1 de la même figure. Les vues C1 sont des vues en coupe dans la direction des lignes de bit, selon un plan CC de la vue C2, illustrant la fabrication d'un transistor MOSFET. Les vues C2 sont des vues en coupe dans la direction des lignes de mot, selon un plan FF de la vue C1, de la structure de la vue C1 de la même figure.

Les vues A1, B1 et C1, respectivement A2, B2 et C2, sont représentées séparément, mais peuvent, en pratique, être situées voisines les unes des autres.

Les vues A2 et B2 illustrent chacune la formation de deux cellules voisines dans la direction des lignes de mot. La vue A1 illustre la formation de deux cellules voisines dans la direction des lignes de bit.

La figure 7 illustre une étape d'un procédé de fabrication du mode de réalisation de la figure 1.

Au cours de cette étape, des murs isolants 80 sont formés dans un substrat semiconducteur 82. Les murs isolants sont de préférence de type tranchée isolante peu profonde ou STI (Shallow Trench Isolation). Des tranchées 80 s'étendent dans la direction des lignes de bit et d'autres tranchées 80 s'étendent dans la direction des lignes de mot de manière à entourer les emplacements de formation de la cellule eSTM, de la cellule 10 et du transistor. Les murs 80 délimitent ainsi des emplacements 81a, 81b et 81c, dans lesquels sont respectivement formés une cellule eSTM, une cellule 10 et un transistor MOSFET. Les murs 80 des vues B1 et B2 correspondent aux murs 25 de la figure 1.

De préférence, les murs 80 dépassent du substrat 82. Autrement dit, les murs 80 s'étendent de manière verticale dans le substrat 82 et hors du substrat, depuis le niveau d'une face supérieure du substrat. De préférence, les murs 80 ne s'étendent pas sur toute la hauteur du substrat. Par exemple, les murs 80 dépassent du substrat sur une hauteur sensiblement égale à 10 nm. Par exemple, les murs 80 s'étendent dans le substrat 82 sur une hauteur sensiblement égale à 350 nm.

De plus, au cours de cette étape, une couche isolante 84 est formée sur la face supérieure du substrat. La couche 84 est par exemple en oxyde de silicium. La couche 84 est par exemple formée simultanément dans les emplacements 81a, 81b et 81c, par croissance sur le substrat. La couche 84 a de préférence une épaisseur inférieure à la hauteur sur laquelle les murs 80 dépassent du substrat. Ainsi, la couche 84 est, au niveau des cellules eSTM, des cellules 10 et des transistors, entourée par les murs 80.

Cette étape comprend, en outre, la formation de couches 18a par implantation de dopants dans le substrat. Les couches 18 sont de préférence en un matériau semiconducteur, par exemple du silicium, par exemple du silicium dopé de type N. Chaque emplacement 81a, 81b et 81c comprend une couche 18a. Les couches 18a des différents emplacements sont par exemple formées lors d'une même implantation.

Les couches 18a sont formées sous le niveau de la face inférieure des murs 80. Ainsi, les couches 18a sont situées plus profondément dans le substrat que les murs 80, par rapport à la face supérieure du substrat. Par exemple, les couches 18a ont une épaisseur comprise entre 1 µm et 10 µm. Par exemple, les couches 18a sont séparées du niveau de la face inférieure des murs 80 par une distance comprise entre 0,5 µm et 1 µm.

L'implantation de dopants est par exemple effectuée dans les emplacements 81a, 81b et 81c, entre les murs 80.

Les couches 18a s'étendent de préférence en regard de toute la face supérieure du substrat situé dans les emplacements 81a, 81b, 81c.

Par exemple, deux cellules eSTM voisines dans la direction des lignes de mot peuvent, comme cela est représenté en vue A2, partager une même couche 18a. La couche 18a s'étend ainsi sous le mur 80 situé entre les deux cellules eSTM. Similairement, deux cellules 10 voisines dans la direction des lignes de mot peuvent, comme cela est représenté en vue B2, partager une même couche 18a. La couche 18a s'étend ainsi sous le mur 80 situé entre les deux cellules 10. De manière plus générale, les couches 18 s'étendent par exemple sous les murs 80 situés entre des cellules mémoire comprenant un caisson semiconducteur (formé par la suite) commun, mais ne s'étendent pas sous les murs 80 séparant une cellule d'un composant, par exemple une cellule ou un transistor, avec lequel il ne partage pas un caisson semiconducteur.

Cette étape comprend en outre la formation d'un caisson 86 dans l'emplacement 81c. Plus précisément, la formation du caisson 86 correspond au dopage du substrat 82 dans l'emplacement 81c. Le caisson 86 est par exemple dopé de type P, par exemple à une concentration comprise entre 10¹⁴ et 5×10¹⁵ at.cm^(-3). Le caisson 86 s'étend de préférence de la couche 84 à la couche 18a de l'emplacement 81c. Ainsi, le caisson 86 s'étend de préférence, dans l'emplacement 81c, de la face supérieure du substrat à la face supérieure de la couche 18a. Par exemple, les emplacements 81a et 81b sont recouverts d'un masque de protection lors de la formation du caisson 86, le masque étant retiré après la formation du caisson 86.

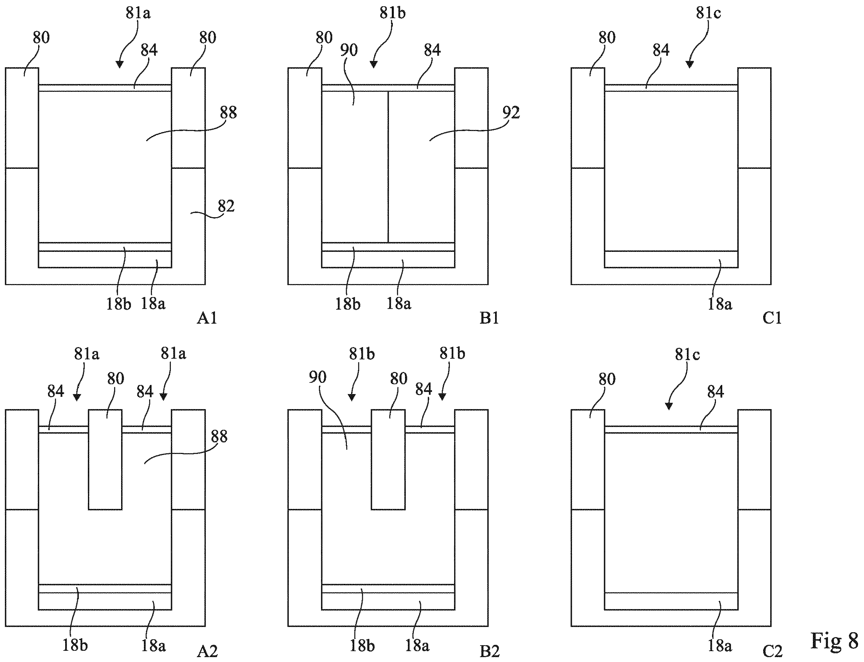

La figure 8 illustre une étape d'un procédé de fabrication du mode de réalisation de la figure 1.

Cette étape comprend la formation de couches 18b dans les emplacements 81a et 81b. Les couches 18b reposent sur les couches 18a. De préférence, les couches 18b recouvrent entièrement les couches 18a des emplacements 81a et 81b. De préférence, les couches 18b sont en contact avec les couches 18a des emplacements 81a et 81b. Les couches 18b sont en silicium dopé de type N. Les couches 18b sont par exemple dopées avec les mêmes dopants que les couches 18a et à une concentration de dopants dans le même ordre de grandeur.

Les couches 18b sont situées entre le niveau des faces inférieures des murs 80 et les couches 18a. Les couches 18b sont ainsi situées plus profondément que les extrémités inférieures des murs 80. De préférence, chaque couche 18b est séparée de la face supérieure par une distance sensiblement égale à 500 nm.

L'empilement des couches 18a et 18b correspond, dans l'emplacement 81b, à la couche 18.

Cette étape de fabrication comprend en outre la formation de caissons 88 et 90. Le caisson 88 est situé dans l'emplacement 81a et le caisson 90 est situé dans l'emplacement 81b. Les caissons 88 et 90 sont par exemple formés simultanément lors d'une même étape d'implantation.

Le caisson 88 s'étend de préférence de la couche 18b à la couche 84, autrement dit de la face supérieure de la couche 18 à la face supérieure du substrat 82. De préférence, toute la région du substrat 82 située dans l'emplacement 81a, au-dessus des couches 18a et 18b, est dopée de manière à former le caisson 88.

Le caisson 88 est par exemple dopé de type P, par exemple dopé avec du bore. La concentration de dopants est par exemple comprise entre 10¹⁴ et 5×10¹⁵ at.cm^ (-3) .

Dans le cas où certaines cellules eSTM partagent une même couche 18a, comme cela est le cas en vue A1 et A2, la couche 18b s'étend sous le mur 80 situé entre lesdites cellules et la région du substrat entre ledit mur 80 et la couche 18b est dopée lors de la formation du caisson. Ainsi, le caisson 88 s'étend entre la couche 18b et le mur 80 situé entre lesdites cellules eSTM.

Le caisson 90 s'étend, dans l'emplacement 81b, de préférence de la couche 18b à la couche 84, autrement dit de la face supérieure de la couche 18 à la face supérieure du substrat 82. De préférence, toute la région du substrat 82 située dans l'emplacement 81b, au-dessus des couches 18a et 18b, est dopée de manière à former le caisson 90.

Le caisson 90 est par exemple dopé de type P, par exemple dopé avec du bore. La concentration de dopants est par exemple comprise entre 10¹⁴ et 5×10¹⁵ at.cm^ (-3). La concentration de dopants est par exemple sensiblement égale à la concentration de dopant dans le caisson 88. La concentration de dopants est de préférence égale à la concentration du caisson 12 de la figure 1.

Dans le cas où certaines cellules 10 partagent une même couche 18a, comme cela est le cas en vue B1 et B2, la couche 18b s'étend sous le mur 80 situé entre lesdites cellules et la région du substrat entre ledit mur 80 et la couche 18b est dopée lors de la formation du caisson 90. Ainsi, le caisson 90 s'étend entre la couche 18b et le mur 80 situé entre lesdites cellules 10.

Cette étape comprend en outre la formation d'un caisson 92 dans le caisson 90 de l'emplacement 81b. Le caisson 92 s'étend par exemple sur la même hauteur que le caisson 90, c'est-à-dire de la couche 18b à la face supérieure du substrat. Le caisson 92 s'étend, de plus, depuis un des murs 80 vers l'autre mur 80, dans le plan de la vue B1, c'est-à-dire dans la direction des lignes de bit. De préférence, le caisson 92 occupe une moitié latérale du caisson 90.

Le caisson 92 correspond au caisson 14 de la figure 1 et la partie du caisson 90 n'étant pas remplacée par le caisson 92 correspond au caisson 12.

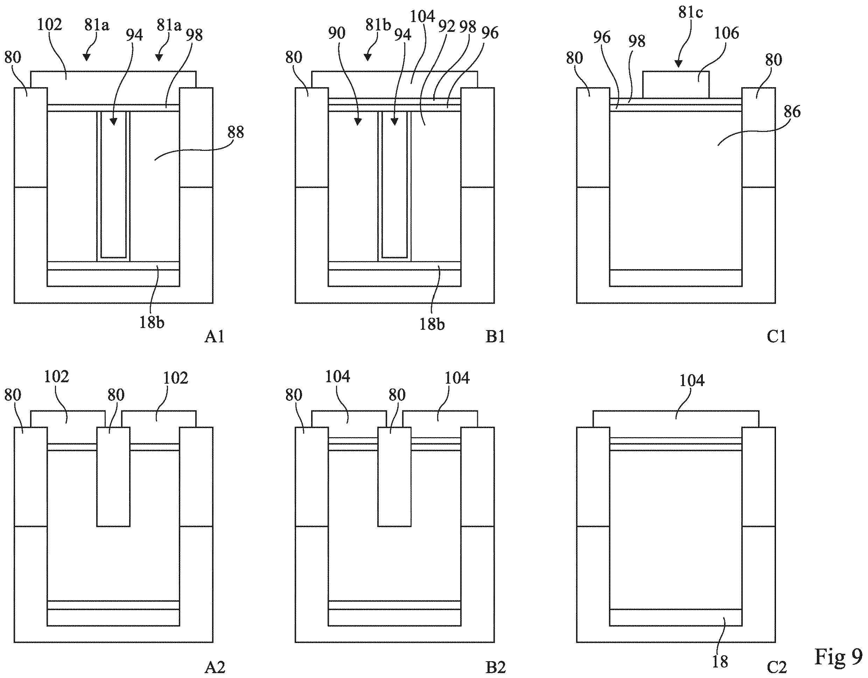

La figure 9 illustre une étape d'un procédé de fabrication du mode de réalisation de la figure 1.

Au cours de cette étape, la couche 84 est retirée des emplacements 81a, 81b et 81c. De plus, des murs 94 sont formés dans les emplacements 81a et 81b.

Chaque mur 94 s'étend, en hauteur, depuis la couche 18b jusqu'à la face supérieure du substrat. Autrement dit, chaque mur 94 s'étend sur toute la hauteur du caisson 88 ou 90. Chaque mur s'étend dans la direction des lignes de mot. De préférence, chaque mur 94 est commun à plusieurs cellules eSTM ou cellules 10. Chaque mur 94 traverse donc les murs 80 situés entre des cellules voisines dans la direction de lignes de mot. Ainsi, les deux cellules eSTM de la vue A2 ont un mur 94 commun, le mur 94 traversant le mur 80 séparant lesdites cellules. De même les deux cellules 10 de la vue B2 ont un mur 94 commun, le mur 94 traversant le mur 80 séparant lesdites cellules.

Chaque mur 94 est situé sensiblement au milieu, dans le plan des vues A1 et B1, de l'emplacement 81a ou 81b dans lequel il se trouve. Ainsi, chaque mur 84 est sensiblement à la même distance de deux murs 80, entourant l'emplacement 81a ou 81b, opposés, parallèles l'un à l'autre et parallèles au mur 94.

Le mur 94 situé dans l'emplacement 81a sépare le caisson 88 en deux caissons sensiblement de mêmes dimensions, séparés par le mur 94, chacun des deux caissons s'étendant dans la direction de la ligne de mot.

Le mur 94 situé dans l'emplacement 81b, correspondant au mur 16 de la figure 1, sépare le caisson 90 et le caisson 92, correspondant aux caissons 12 et 14 de la figure 1.

Les murs 94 sont de préférence formés simultanément. Les murs 94 sont de préférence identiques les uns aux autres. Chaque mur 94 comprend un cœur conducteur ou semiconducteur, par exemple en silicium polycristallin, et une enveloppe isolante, par exemple en oxyde de silicium.

Cette étape comprend, en outre, la formation d'une couche isolante 96 dans les emplacements 81b et 81c. La couche 96 est par exemple en oxyde de silicium. La couche 96 s'étend de préférence sur toute la face supérieure du substrat dans les emplacements 81a et 81b. Ainsi, dans l'emplacement 81c, la couche 96 s'étend entre les murs 80, de manière à recouvrir le caisson 86. Dans l'emplacement 81b, la couche 96 s'étend entre les murs 80, de manière à recouvrir le caisson 90, le caisson 92 et le mur 94.

Cette étape comprend de plus la formation d'une couche isolante 98 dans les emplacements 81a et 81b. La couche 98 est par exemple en oxyde de silicium. La couche 98 s'étend de préférence en regard de toute la face supérieure du substrat dans les emplacements 81a et 81b. Ainsi, dans l'emplacement 81a, la couche 96 s'étend entre les murs 80, de manière à recouvrir le caisson 88 et le mur 94. Dans l'emplacement 81b, la couche 96 s'étend entre les murs 80, de manière à recouvrir entièrement la couche 96, et donc s'étendre en regard du caisson 90, du caisson 92 et du mur 94.

La couche 96 a par exemple une épaisseur comprise entre 7 et 8 nm. La couche 98 a par exemple une épaisseur comprise entre 7 et 8 nm. De manière plus générale, les épaisseurs des couches 96 et 98 sont telles que l'empilement des couches 96 et 98 ne dépasse pas hors des murs.

Cette étape comprend de plus la formation d'une couche semiconductrice, de préférence en silicium poly cristallin. Ladite couche est par exemple formée sur l'ensemble de la structure, en particulier dans les emplacements 81a, 81b et 81c et sur les murs 80. Ladite couche est par exemple lissée, par exemple par un procédé de polissage mécano-chimique (en anglais, Chemical mechanical polishing ou CMP), de manière que la face supérieure de ladite couche soit plane. Ladite couche est ensuite gravée de manière à former des bandes 102 dans les emplacements 81a, des bandes 104 dans les emplacements 81b et des bandes 106 dans les emplacements 81c. Les bandes 102, 104 et 106 sont de préférence formées simultanément durant une même étape de gravure de la couche.

Chaque bande 102 ou 104 recouvre entièrement l'emplacement 81a, 81b où elle est située. De plus, les bandes 102 et 104 recouvre partiellement les murs 80 délimitant les emplacements 81a et 81b. De préférence, les bandes 102, 104 et 106 ne sont pas en contact avec les autres bandes 102, 104 ou 106.

Dans le cas où des cellules eSTM et des cellules 10 sont voisines, c'est-à-dire si des emplacements 81a et 81b sont voisins, les couches 102 et 104 des cellules voisines peuvent être communes.

Les bandes 106 sont formées de manière à constituer les grilles des transistors. Ainsi, la bande 106 d'un emplacement 81c s'étend sur toute la longueur, c'est-à-dire la dimension dans la direction de la ligne de mot, de l'emplacement 81c, et au moins partiellement sur les murs 80 délimitant l'emplacement 81c dans la direction de la ligne de mot. La bande 106 d'un emplacement 81c s'étend partiellement sur la largeur, c'est-à-dire la dimension dans la direction de la ligne de bit, de l'emplacement 81c, de préférence au centre de l'emplacement 81c. Une partie des caissons 86 n'est pas en regard de bandes 106. Plus précisément les régions correspondant aux régions de source et de drain des transistors ne sont pas en regard de bandes 106.

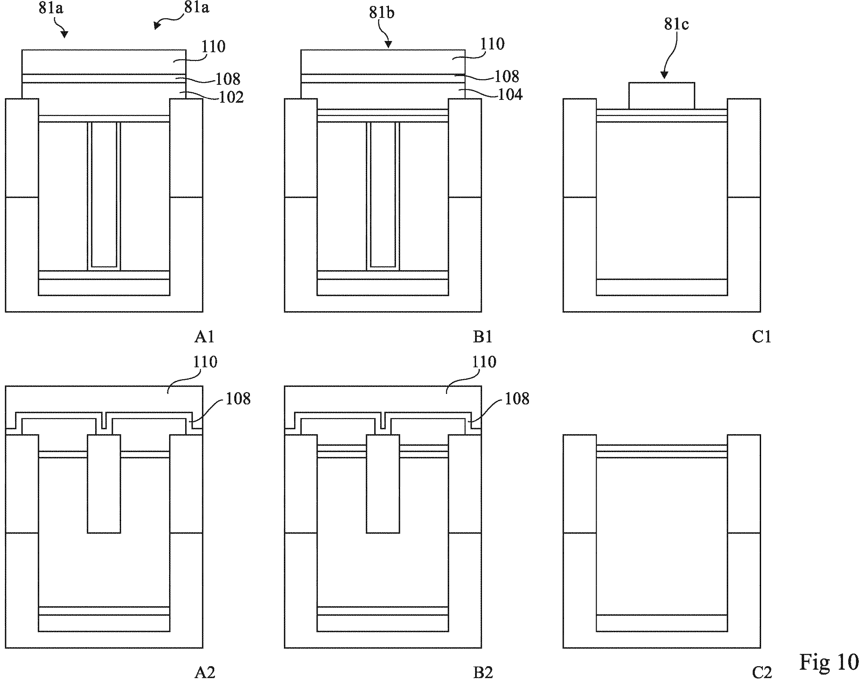

La figure 10 illustre une étape d'un procédé de fabrication du mode de réalisation de la figure 1.

Au cours de cette étape, une couche isolante 108 est formée sur l'ensemble de la structure. La couche 108 est de préférence un empilement d'une couche d'oxyde de silicium, d'une couche de nitrure de silicium et une couche d'oxyde de silicium. Une couche semiconductrice 110, de préférence en silicium polycristallin est formée, par exemple sur l'ensemble de la structure, en particulier dans les emplacements 81a, 81b et 81c et sur les murs 80. Ladite couche recouvre ainsi la couche 108. La couche 110 est par exemple lissée, par exemple par un procédé de polissage mécano-chimique (en anglais, Chemical mechanical polishing ou CMP), de manière que la face supérieure de la couche 110 soit plane.

Dans le cas où des cellules eSTM et des cellules 10 sont voisines, c'est-à-dire si des emplacements 81a et 81b sont voisins, les couches 108 et 110 des cellules voisines peuvent être communes.

Les couches 108 et 110 sont ensuite gravées, de préférence simultanément. Les couches 108 et 110 sont ensuite entièrement gravées des emplacements 81c.

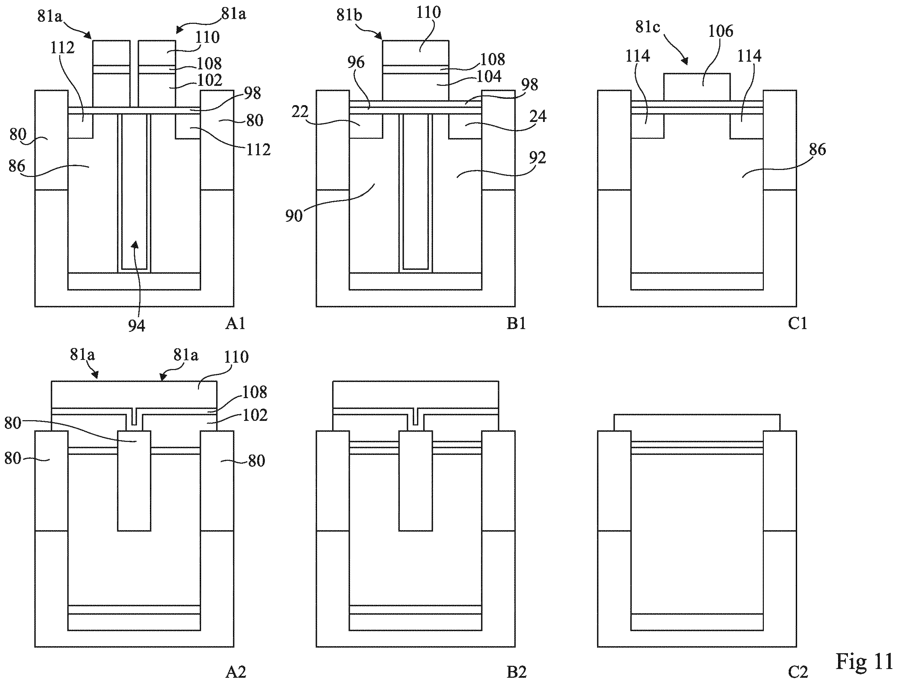

La figure 11 illustre une étape d'un procédé de fabrication du mode de réalisation de la figure 1.

Au cours de cette étape, les empilements des couches 102, 108 et 110 dans les emplacements 81a et les empilements des couches 104, 108 et 110 dans les emplacements 81b sont gravés. Plus précisément, les empilements des couches 104, 108 et 110 dans les emplacements 81b sont gravés de manière à former l'empilement de couches 26, 29 et 28 de la figure 1. Ainsi, les couches 96 et 98 de l'emplacement 81b correspondent à la couche 27 de la figure 1, la couche 104 de l'emplacement 81b correspond à la couche 26 de la figure 1, la couche 108 de l'emplacement 81b correspond à la couche 29 de la figure 1, et la couche 110 de l'emplacement 81b correspond à la couche 28 de la figure 1.

L'empilement des couches 102, 108 et 110 dans l'emplacement 81A est gravé de manière à former deux empilements, de préférence identiques, comprenant la couche 102, la couche 108 et la couche 110. Ainsi, chaque cellule eSTM, c'est-à-dire chaque emplacement 81a, comprend un empilement d'une couche 102, d'une couche 108 et d'une couche 110. Ledit empilement de chaque cellule eSTM s'étend, dans la direction des lignes de mot, c'est-à-dire dans le plan de la vue A2, d'un mur 80 délimitant l'emplacement 81a, au mur 80 opposé délimitant l'emplacement 81a. Ledit empilement de chaque cellule eSTM s'étend, dans la direction des lignes de bit, c'est-à-dire dans le plan de la vue A1, partiellement sur la face supérieure du caisson 88, d'un coté du mur 94. Ainsi, deux empilements sont représentés dans la vue A1, les empilements étant situés sur la couche 98, un de chaque côté du mur 94. Chaque empilement s'étend, dans la direction de la ligne de bit, à partir du mur 94 et vers le mur 80. Chaque empilement s'étend, dans la direction de la ligne de bit, partiellement en regard de la partie du caisson 88 du même coté du mur 94. Ainsi, de chaque coté du mur 94, une partie du caisson 88 n'est pas en regard de l'empilement, ladite partie étant de préférence le long d'un mur 80, séparée du mur 94 par une partie du caisson 88 recouverte par l'empilement. De préférence, l'empilement n'est pas situé en regard du mur 94.

Les couches 102 de chaque cellule sont indépendantes des couches 102 des autres cellules. En particulier, les couches 102 sont séparées les unes des autres par la couche 108. Chaque couche 110 est par exemple commune à des cellules voisines dans la direction des lignes de mot.

Cette étape comprend en outre une étape d'implantation de caissons plus fortement dopés en surface du substrat. Plus précisément, cette étape comprend l'implantation de dopants de type N :
- dans les emplacements 81a, de manière à former des caissons 112 en surface des caissons 88, dans les régions n'étant pas en regard d'empilements de couches 102, 108 et 110 ;
- dans les emplacements 81b, de manière à former le caisson 22 dans le caisson 90, c'est-à-dire dans le caisson 12 (figure 1) ; et
- dans les emplacements 81c, de manière à former des régions de source et de drain 114 dans les régions du caisson 86 non recouvertes par la couche 106.

Les caissons 112, 22, 24 et 114 sont de préférence formés simultanément, lors d'une même étape d'implantation. Les caissons 112, 22, 24 et 114 ont donc de préférence une même concentration de dopants.

De plus, cette étape comprend aussi l'implantation de dopants de type P dans l'emplacement 81b, de manière à former le caisson 24 dans le caisson 92, c'est-à-dire le caisson 14 (figure 1).

Un avantage des cellules 10 formées par le procédé décrit par les figures 7 à 11 est que l'épaisseur de la couche isolante 27 (figure 1), correspondant à l'empilement de la couche 96 et de la couche 98 (figure 9), est plus épaisse que la couche d'oxyde d'une cellule eSTM connue, ce qui entraine une meilleure fiabilité.

Un avantage des modes de réalisation décrits précédemment est qu'il est possible d'effacer chaque cellule indépendamment des autres cellules de la ligne de la matrice et de la colonne de la matrice.

Un autre avantage des modes de réalisation décrits est que les potentiels utilisés lors de l'étape d'effaçage peuvent être adaptés au dispositif. Ainsi, il est possible d'utiliser des potentiels uniquement positifs, des potentiels uniquement négatifs, ou des potentiels positifs et négatifs, mais relativement proches de la masse.

Un autre avantage des modes de réalisation décrits est qu'ils sont plus fiables que des mémoires eSTM connues, grâce à l'épaisseur de l'oxyde.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, le transistor formé par le procédé des figures 7 à 11 peut être un transistor à canal P. Le procédé de fabrication diffère uniquement en ce que le caisson 86 est dopé de type N et que les caissons 114 sont dopés de type P et sont formés lors de l'implantation de dopants de type P formant le caisson 24.

Enfin, la mise en œuvre pratique des modes de réalisation et variantes décrits est à la portée de la personne du métier à partir des indications fonctionnelles données ci-dessus.

## Revendications

1. Cellule mémoire (10, 50) comprenant :
un premier caisson (22, 58) dopé d'un premier type de conductivité (N+), en contact avec un deuxième caisson (12, 52) dopé d'un deuxième type de conductivité (P), le deuxième type de conductivité étant opposé au premier type de conductivité ;
un troisième caisson (24, 60) dopé du deuxième type de conductivité (P+), en contact avec un quatrième caisson (14, 54) dopé du premier type de conductivité (N) ;
un premier mur (16, 64) en contact avec les deuxième (12, 52) et quatrième (14, 54) caissons, le premier mur comprenant un coeur (16a, 64a) conducteur ou semiconducteur et une enveloppe isolante (16b, 64b) ;
un empilement d'une première couche isolante (27, 71), d'une première couche semiconductrice (26, 72), d'une deuxième couche isolante (29, 73) et d'une deuxième couche semiconductrice (28, 74) recouvrant au moins partiellement les deuxième (12, 52) et quatrième (14, 54) caissons ; et
une troisième couche semiconductrice (18) sur laquelle reposent les deuxième (12, 52) et quatrième (14, 54) caissons et le mur (16, 64).

2. Cellule selon la revendication 1, dans lequel le premier type de conductivité est le type N, et le deuxième type de conductivité est le type P.

3. Cellule selon la revendication 1 ou 2, dans lequel les deuxième (12) et quatrième (14) caissons sont séparés par le premier mur conducteur (16).

4. Cellule selon la revendication 3, dans lequel l'empilement de couches recouvre le premier mur (16).

5. Cellule selon l'une quelconque des revendications 1 à 4, dans lequel la troisième couche (18) est séparée du quatrième caisson (14) par un caisson (42) semiconducteur dopé du deuxième type de conductivité.

6. Cellule selon la revendication 1 ou 2, dans lequel les deuxième (52) et quatrième (54) caissons sont séparés par un deuxième mur isolant (56).

7. Cellule selon la revendication 6, dans lequel l'empilement de couches recouvre le deuxième mur (56).

8. Mémoire comprenant une matrice de cellules mémoire selon l'une quelconque des revendications 1 à 7, dans lequel chaque colonne de la matrice comprend une deuxième couche semiconductrice (28, 74) et un premier mur (16, 64) commun aux cellules de la colonne.

9. Procédé de commande d'une cellule mémoire selon l'une quelconque des revendications 1 à 7, comprenant une étape de programmation durant laquelle :
les deuxième (12, 52), troisième (14, 54) et quatrième (24, 60) caissons et la troisième couche (18) sont à un premier potentiel de référence ;
le premier caisson (22, 58) est mis à un deuxième potentiel positif, supérieur au premier potentiel de référence ;
la deuxième couche (28, 74) est mise à un troisième potentiel positif, supérieur au deuxième potentiel positif ; et
le premier mur (16, 64) est mis à un quatrième potentiel égal à la tension de seuil d'un transistor équivalent aux premier, deuxième, et troisième caissons et à l'empilement de couches.

10. Procédé selon la revendication 9, dans lequel le premier potentiel de référence est la masse, le deuxième potentiel positif est sensiblement égal à 5 V, le troisième potentiel est sensiblement égal à 12 V, et le quatrième potentiel est compris entre 0,5 V et 1,5V.

11. Procédé de commande d'une cellule mémoire selon l'une quelconque des revendications 1 à 7, comprenant une étape de lecture durant laquelle :
les deuxième (12, 52), troisième (14, 54) et quatrième (24, 60) caissons et la deuxième couche semiconductrice (28, 74) et la troisième (18) couche sont à un cinquième potentiel de référence ;
le premier caisson (22, 58) est mis à un sixième potentiel positif, supérieur au cinquième potentiel de référence ;
le premier mur (16, 64) est mis à un septième potentiel positif, supérieur au sixième potentiel positif.

12. Procédé selon la revendication 11, dans lequel le cinquième potentiel de référence est la masse, le sixième potentiel positif est sensiblement égal à 0,7 V, et le septième potentiel positif est sensiblement égal à 3 V.

13. Procédé de commande d'une cellule mémoire selon l'une quelconque des revendications 1 à 7, comprenant une étape d'effaçage durant laquelle :
les premier (22, 58), deuxième (12, 52) et troisième (14, 54) caissons et la troisième couche (18) sont à un huitième potentiel de référence ;
le quatrième caisson (24, 60) est mis à un neuvième potentiel, inférieur au huitième potentiel de référence ;
la deuxième couche semiconductrice (28, 74) est mise à un dixième potentiel, inférieur au neuvième potentiel ; et
le premier mur (16, 64) est mis à un onzième potentiel égal à la tension de seuil d'un transistor équivalent aux deuxième, troisième et quatrième caissons et à l'empilement de couches.

14. Procédé selon la revendication 13, dans lequel le huitième potentiel de référence est la masse, le neuvième potentiel est sensiblement égal à -5 V, le dixième potentiel est sensiblement égal à -10 V et le onzième potentiel est compris entre -1,5 V et -0,5 V.

15. Procédé selon la revendication 13, dans lequel le huitième potentiel de référence est sensiblement égal à 10 V, le neuvième potentiel est sensiblement égal à 5 V, le dixième potentiel est la masse et le onzième potentiel est compris entre 5 V et 15 V.

16. Procédé selon la revendication 13, dans lequel le huitième potentiel de référence est sensiblement égal à 5 V, le neuvième potentiel est la masse, le dixième potentiel est sensiblement égal à -5 V et le onzième potentiel est compris entre 0 V et 10 V.

17. Procédé selon la revendication 9 ou 10 et selon l'une quelconque des revendications 13 à 16, dans lequel l'étape de programmation et l'étape d'effaçage ont sensiblement la même durée.

18. Procédé de fabrication d'une cellule mémoire selon l'une quelconque des revendications 1 à 5, comprenant :
a. la formation de la troisième couche semiconductrice (18, 18a, 18b) par implantation de dopants dans un substrat semiconducteur (82) ;
b. la formation du deuxième caisson (12, 90) par implantation de dopants dans le substrat ;
c. la formation du quatrième caisson (14, 92) par implantation de dopants dans le substrat ;
d. la formation du premier mur (16) entre les deuxième et troisième caissons ;
e. la formation de l'empilement sur une partie des deuxième (12) et quatrième (14) caissons et sur le premier mur (16) ;
f. la formation du premier caisson par implantation de dopants dans le deuxième caisson ; et
g. la formation du troisième caisson par implantation de dopants dans le quatrième caisson.

19. Procédé de fabrication d'une première cellule mémoire selon l'une quelconque des revendications 1 à 5 et d'une deuxième cellule mémoire de type eSTM, dans lequel la première cellule mémoire est formée par les étapes a, b, c, d, e, f, et g du procédé de la revendication 18, la deuxième cellule mémoire étant formée par les étapes a, b, d, e, f.

20. Procédé de fabrication d'une première cellule mémoire selon l'une quelconque des revendications 1 à 5 et d'un transistor, la première cellule étant formée par le procédé de la revendication 18, dans lequel la grille du transistor est formée par l'étape e et les régions de drain et de sources sont formées par l'étape f ou g.

21. Procédé de fabrication d'une première cellule mémoire selon l'une quelconque des revendications 1 à 5, d'un transistor et d'une deuxième cellule mémoire de type eSTM, la première cellule étant formée par le procédé de la revendication 18, la deuxième cellule étant formée par le procédé de la revendication 19 et le transistor étant formé par le procédé de la revendication 20.
